# EUROPEAN PATENT APPLICATION

(11) **EP 1 598 864 A2**
(43) Date of publication of application: **23.11.2005**
(21) Application number: 05251714.1
(22) Date of filing: 21.03.2005
(51) Int. Cl.: H01L 21/68, C09J 7/02

(54) **Hardenable pressure-senstitive adhesive sheet for semiconductors and process for producing a semiconductor device**

(30) Priority: 19.03.2004 JP 2004080701
(71) Applicant: Lintec Corporation, Tokyo-To (JP)
(72) Inventor: Saiki, Naoya, Koshigaya-shi Saitama (JP); Yamazaki, Osamu, Saitama-shi Saitama (JP); Hamasaki, Akie, Tokyo (JP)
(74) Representative: Towler, Philip Dean

(57) **Abstract**

Disclosed herein is a hardenable pressure-sensitive adhesive sheet enabling production of a semiconductor device of high reliability while preventing the occurrence of package cracking and other failures. Also disclosed is a process for producing a semiconductor device using the hardenable pressure-sensitive adhesive sheet. A hardenable pressure-sensitive adhesive sheet of the invention has
a hardenable pressure-sensitive adhesive layer comprising a pressure-sensitive component (A) and an epoxy resin (B), wherein the hardenable pressure-sensitive adhesive layer after thermal curing has a storage modulus of 1.0×10⁷ Pa or below at 100°C and 1.0×10⁵ Pa or above at 160°C.

## Description

### FIELD OF THE INVENTION

The present invention relates to a novel hardenable pressure-sensitive adhesive (hereinafter "HPSA") sheet for semiconductors and a process for producing a semiconductor device. More particularly, the present invention relates to a HPSA sheet suitable for use in the steps of dicing a silicon wafer, etc. and effecting die bonding thereof to a lead frame, and relates to a process for producing a semiconductor device with the use of the HPSA sheet.

### BACKGROUND OF THE INVENTION

A semiconductor wafer of silicon, gallium arsenide, etc. is produced with a large diameter. The wafer is sequentially subjected to the steps of cut separation (dicing) into small element pieces (IC chips) and mounting thereof. In particular, a semiconductor wafer in the state of being stuck to a pressure-sensitive adhesive ("PSA") sheet is sequentially subjected to the steps of dicing, washing, drying, expanding and pick-up and thereafter to the subsequent step of bonding.

Various HPSA sheets for semiconductors having both a wafer fixing function and a die bonding function have been proposed in order to simplify the procedure from the pickup step through to the bonding step. See, for example, Japanese Patent Laid-open Publication No. 9(1997)-100450. In this reference, there is disclosed a HPSA sheet comprising a base material and, superimposed thereon, a HPSA layer comprising a composition containing a radiation curable pressure-sensitive component and a thermosetting adhesive component. This HPSA layer has the function of fixing a wafer during the wafer dicing step. When chip pick-up is performed after the completion of dicing, the HPSA layer is detached from the base material together with the chips. When the IC chips accompanied by the HPSA layer are mounted on a substrate and heated, the thermosetting adhesive component of the HPSA layer exerts an adhesive strength to thereby complete the bonding of the IC chips to the substrate.

This HPSA sheet for semiconductors may also be used for the mutual bonding of IC chips.

With respect to the above HPSA sheet, when a general-purpose epoxy resin is used as the thermosetting adhesive component, the adherence thereof is high so that the application to a wide variety of uses is promising. However, in the IR reflow operation, etc. of reliability test, warpage of the substrate and chips and delamination between the substrate and chips has tended to increase as the thickness of the silicon chips decreases.

The cause of this problem would be a difference in thermal expansion coefficient between the silicon chips and the surface material (organic material such as a polyimide) of the substrate on which the silicon chips are mounted. In a comparison of thermal expansion coefficients, the coefficient of silicon wafer is in the range of 3 to 5×10⁻⁶/°C while that of common polyimide is 3 to 5×10⁻⁵/°C. Consequently, under heat cycle conditions, the HPSA layer interposed between the silicon chips and the substrate suffers a stress attributed to the difference in thermal expansion coefficient. In particular, when the storage modulus of the HPSA layer is high, warpages of the substrate and chips and delamination between the substrate and chips have occurred.

Therefore, there is a demand for the development of a HPSA layer that, while retaining the high adherence of epoxy resin after thermal curing, exhibits low storage modulus at high temperatures and enables reduction of the stress between the substrate and chips.

### SUMMARY OF THE INVENTION

Accordingly, the invention provides:
[1] A HPSA sheet for semiconductors comprising a base material and, superimposed thereon, a HPSA layer comprising a pressure-sensitive component (A) and an epoxy resin (B), wherein the HPSA layer after thermal curing has a storage modulus of 1.0×10⁷ Pa or below at 100°C and 1.0×10⁵ Pa or above at 160°C.
[2] The HPSA sheet as described in [1], wherein the HPSA layer contains a radiation curable component.
[3] A process for producing a semiconductor device, comprising the steps of:
   sticking a semiconductor wafer to the HPSA layer of the HPSA sheet of [1],
   dicing the semiconductor wafer into IC chips,
   detaching the IC chips with the HPSA layer from the base material,
   attaching the IC chips on a lead frame with the HPSA layer interposed therebetween, and
   heating so that the HPSA layer exerts an adhesive strength to thereby accomplish bonding of the IC chips to the lead frame.
[4] A process for producing a semiconductor device, comprising the steps of:
   sticking a semiconductor wafer to the HPSA layer of the HPSA sheet of [2],
   dicing the semiconductor wafer into IC chips, irradiating the HPSA layer either prior to the dicing or after the dicing so as to cure the HPSA layer,
   detaching the IC chips with the HPSA layer from the base material,
   attaching the IC chips on a lead frame with the HPSA layer interposed therebetween, and
   heating so that the HPSA layer exerts an adhesive strength to thereby accomplish bonding of the IC chips to the lead frame.

### EFFECT OF THE INVENTION

The present invention provides a HPSA sheet for semiconductors, which sheet has excellent versatility and adherence, and by which a semiconductor device of high reliability can be produced that is free from the warpage and delamination of substrate and chips, even when exposed to heat cycle conditions.

### DETAILED DESCRIPTION OF THE INVENTION

The HPSA sheet of the present invention and the process for producing a semiconductor device with the use of the HPSA sheet will be described in detail below.

The HPSA sheet for semiconductors according to the present invention can have any configuration. For example, it can have the form of a tape or label.

The HPSA sheet for semiconductors according to the present invention comprises a base material and, superimposed thereon, a HPSA layer, the HPSA layer comprising a pressure-sensitive component (A) and an epoxy resin (B). If necessary, the HPSA layer may further comprise a thermally activated latent curing agent (C), a coupling agent (D), a radiation curable component (E), a flexible component (F), a filler (G) and/or other components (H).

The HPSA sheet for semiconductors according to the present invention is characterized in that the storage modulus of the HPSA layer after thermal curing falls within a specified range.

In particular, the storage modulus at 100°C of the HPSA layer after thermal curing is 1.0×10⁷ Pa or below, preferably in the range of 1.0×10⁶ to 1.0×10⁷ Pa. When the storage modulus at 100°C is larger than 1.0×10⁷ Pa, in the IR reflow operation, etc., the substrate and chips are likely to suffer warpage and delamination.

The storage modulus at 160°C of the HPSA layer after thermal curing is 1.0×10⁵ Pa or above, preferably in the range of 5.0×10⁵ to 1.0×10⁷ Pa. When the storage modulus at 160°C is less than 1.0×10⁵ Pa, voids are likely to occur in the HPSA layer and there is the danger of package cracking in the IR reflow and other steps.

The glass transition temperature (Tg) of the HPSA layer after thermal curing is preferably 120°C or below, more preferably 90°C or below, while the lower limit is preferably 40°C or higher.

Various conventional PSAs can be used as the pressure-sensitive component (A) without particular limitation. In the present invention, it is preferred to use an acrylic PSA, a rubber-based PSA or a polyester-based PSA. Of these, an acrylic PSA is especially preferred.

An example of the acrylic PSA is a (meth) acrylic ester copolymer composed of structural units derived from a (meth)acrylic ester monomer and a (meth)acrylic acid derivative. As the (meth) acrylic ester monomer, use can be made of any of a cycloalkyl (meth) acrylate, benzyl (meth)acrylate and an alkyl (meth)acrylate wherein the alkyl has 1 to 18 carbon atoms. Of these, especially preferred is an alkyl (meth)acrylate wherein the alkyl has 1 to 18 carbon atoms, such as methyl acrylate, methyl methacrylate, ethyl acrylate, ethyl methacrylate, propyl acrylate, propyl methacrylate, butyl acrylate or butyl methacrylate. As the (meth) acrylic acid derivative, there can be mentioned, for example, (meth)acrylic acid, hydroxyethyl (meth) acrylate, glycidyl (meth) acrylate or the like.

When glycidyl (meth)acrylate is used as the (meth)acrylic acid derivative, the resultant ester copolymer has an enhanced compatibility with the later described epoxy resin and,after curing, has high Tg so as to realize enhanced heat resistance. Introduction of a hydroxylated monomer, such as hydroxyethyl acrylate, would facilitate controlling the adherence of adherends and the tackiness properties.

The weight average molecular weight of the (meth)acrylic ester copolymer for use in the acrylic pressure sensitive adhesive is preferably 100,000 or more, especially preferably in the range of 150, 000 to 1, 000, 000. The (meth)acrylic ester copolymer has generally a glass transition temperature of 20°C or below, preferably in the range of -70 to 0°C, and exhibits tackiness at room temperature (23°C).

The epoxy resin (B) has a marked influence on the storage modulus of the HPSA layer after thermal curing. Accordingly, the epoxy resin (B) is appropriately selected so that the storage modulus of the HPSA layer after thermal curing falls within the above range.

Although the epoxy resin (B) is not particularly limited, use can be made of, for example, a blend of general-purpose epoxy resin and epoxy resin having a bisphenol skeleton and a flexible skeleton. The epoxy resin having a bisphenol skeleton and a flexible skeleton is, for example, as follows:

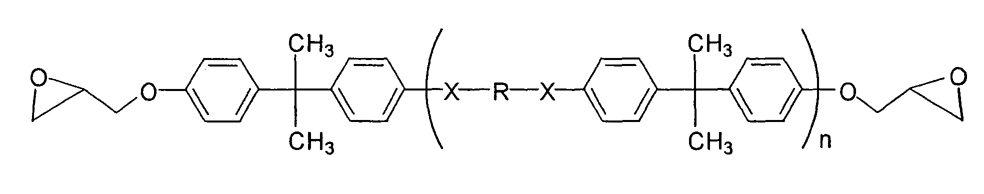

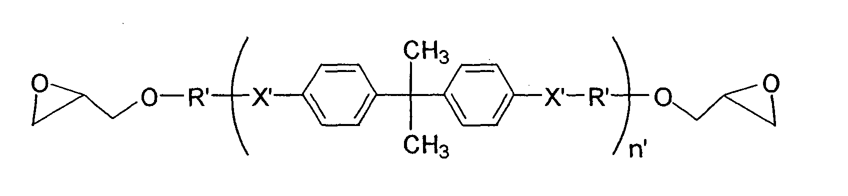

In the above formulae, although the bonding groups X and X' are not particularly limited, there can be mentioned, for example, an ether bond (O), an ester bond (COO, OCO) and the like. An ether bond of relatively low polarity is preferred. R and R' are not limited as long as they are flexible bonding groups such as aliphatic groups. For example, there can be mentioned, having or not having a side chain, an alkylene, polyether skeleton, polybutadiene skeleton, polyisoprene skeleton, etc. n and n' are each a number from 1 to 10.

Hereinafter, the epoxy resin having a bisphenol skeleton and a flexible skeleton may be referred to as "flexible epoxy resin".

The epoxy equivalent of flexible epoxy resin is preferably in the range of 100 to 1000 g/eq, still preferably 200 to 600 g/eq. With respect to the product of curing of the flexible epoxy resin, the glass transition temperature (Tg) is preferably 100°C or below, more preferably 80°C or below.

When this flexible epoxy resin is used as the epoxy resin (B), after thermal curing, not only the glass transition temperature of HPSA layer but also the storage modulus of HPSA layer tends to lower.

As this flexible epoxy resin, there can be mentioned, for example, EXA-4850-150 and EXA-4850-1000 produced by Dainippon Ink And Chemicals, Inc. and Denacol EX-250 and EX250L produced by Nagase Chemtex Corporation.

As the general-purpose epoxy resin mixed with this flexible epoxy resin, it is generally preferred to employ those of about 300 to 2000 molecular weight. In particular, there can be mentioned a liquid epoxy resin in the ordinary state having a molecular weight of 300 to 1000, preferably 330 to 800, a solid epoxy resin in the ordinary state having a molecular weight of 400 to 2500, preferably 800 to 2000, and a blend thereof. The epoxy equivalent of these general-purpose epoxy resins is generally in the range of 50 to 5000 g/eq. Examples of these epoxy resins include glycidyl ethers of phenols such as bisphenol A, bisphenol F, resorcinol, phenyl novolak and cresol novolak; epoxy resins containing a dicyclopentadiene skeleton; glycidyl ethers of carboxylic acids such as phthalic acid, isophthalic acid and tetrahydrophthalic acid; glycidyl type or alkylglycidyl type epoxy resins obtained by substituting an active hydrogen bonded to nitrogen atom of aniline isocyanurate, etc. with a glycidyl group; and epoxy resins having an epoxy group introduced therein through, for example, oxidation of an intramolecular carbon to carbon double bond, known as an alicyclic epoxide, such as vinylcyclohexane diepoxide, 3,4-epoxycyclohexylmethyl 3,4-dicyclohexanecarboxylate and 2-(3,4-epoxy)cyclohexyl-5,5-spiro(3,4-epoxy)cyclohexane-m-dioxane.

Of these, preferred use is made of a bisphenol glycidyl type epoxy resin, an o-cresol novolak type epoxy resin, a phenol novolak type epoxy resin and an epoxy resin having a dicyclopentadiene skeleton.

These general-purpose epoxy resins can be used alone, or in combination. Also, use can be made of a modified resin resulting from modification in advance of the general-purpose epoxy resin together with the flexible component (F) described later. This modified resin is called an alloy modified resin or rubber blend modified resin.

When epoxy resins of low molecular weight and low epoxy equivalent are used, the storage modulus of the HPSA layer after thermal curing tends to increase. The appropriate epoxy resin (B) can be obtained by mixing the flexible epoxy resin with the general-purpose epoxy resin so that the average epoxy equivalent thereof falls preferably within the range of 200 to 800 g/eq, more preferably 300 to 800 g/eq and especially preferably 500 to 700 g/eq. When the average epoxy equivalent is below 200 g/eq, the shrinkage at thermal curing may increase so as to cause a decrease of adhesive strength. On the other hand, when the average epoxy equivalent exceeds 800 g/eq, the crosslink density after curing may be low so as to fail to realize satisfactory bonding strength.

The content of liquid epoxy resin whose epoxy equivalent is 500 g/eq or below is preferably in the range of 20 to 90 wt.%, more preferably 30 to 80 wt.%, and especially preferably 40 to 70 wt.%, based on the weight of the epoxy resin (B). When the content is less than 20 wt.%, embedding performance when bonding to the substrate may be adversely affected.

The epoxy resin (B) is preferably used in an amount of 50 to 1500 parts by weight, more preferably 100 to 1000 parts by weight and especially preferably 200 to 800 parts by weight per 100 parts by weight of the pressure-sensitive component (A). When the amount is less than 50 parts by weight, satisfactory adhesive strength may be unattainable. On the other hand, when the amount exceeds 1500 parts by weight, the cured product is likely to become so brittle that the adhesive strength is unsatisfactory or the attachment performance is poor.

The thermally activated latent curing agent (C) is a curing agent with such characteristics that it does not react with epoxy resins at room temperature but, when heated to a given temperature or higher, is activated to thereby react with epoxy resins.

The activation of the thermally activated latent curing agent (C) can be accomplished by, for example, the method in which chemical reaction is induced by heating to thereby generate active species (anion or cation); the method in which stable dispersion in the epoxy resin is ensured at about room temperature but, when heated to high temperature, compatibilization with the epoxy resin or dissolution therein occurs to thereby initiate a curing reaction; the method in which use is made of a curing agent sealed in a molecular sieve that is fused out at high temperature to thereby initiate a curing reaction; or the method in which use is made of a microcapsule.

The thermally activated latent curing agents (C) can be used alone or in combination. For example, dicyandiamide, an imidazole compound or a mixture thereof can preferably be used.

The above thermally activated latent curing agent (C) is preferably used in an amount of 0.1 to 20 parts by weight, more preferably 0.5 to 15 parts by weight, and especially preferably 1 to 10 parts by weight per 100 parts by weight of the epoxy resin (B).

The coupling agent (D) preferably has a group capable of reacting with functional groups of the above component (A) or (B). Organic functional groups of the coupling agent (D) would react with the epoxy resin, so that the coupling agent (D) can enhance the adherence of curing product without detriment to the thermal stability thereof and can further enhance the water resistance of the cured product. A silane coupling agent is preferably used as the coupling agent. This coupling agent is preferably used in an amount of 0.1 to 20 parts by weight, more preferably 0.5 to 10 parts by weight per 100 parts by weight of the epoxy resin.

The radiation curable component (E) is a compound that, when irradiated with e.g. ultraviolet radiation or electron beams, undergoes polymerization and curing. As the radiation polymerizable compound, use can be made of, for example, acrylate compounds such as trimethylolpropane triacrylate, tetramethylolmethane tetraacrylate, pentaerythritol triacrylate, dipentaerythritol monohydroxypentaacrylate, dipentaerythritol hexaacrylate, 1,4-butylene glycol diacrylate, 1, 6-hexanediol diacrylate, polyethylene glycol diacrylate, oligoester acrylate, urethane acrylate oligomer, epoxy-modified acrylate, polyether acrylate and itaconic acid oligomer. These compounds each have at least one polymerizable double bond in the molecule thereof, and the weight average molecular weight thereof is generally in the range of 100 to 30,000, preferably about 300 to 10,000.

Further, compounds having a dicyclopentadiene skeleton and the like can be used as other examples of the radiation polymerizable compounds.

The HPSA composition containing the above radiation curable component (E) is cured when irradiated. Examples of suitable radiation include ultraviolet light, electron beams, etc.

When ultraviolet radiation is used, the polymerization and curing time and radiation dose can be reduced by mixing a photopolymerization initiator into the above composition.

Examples of the photopolymerization initiator include benzophenone, acetophenone, benzoin, benzoin methyl ether, benzoin ethyl ether, benzoin isopropyl ether, benzoin isobutyl ether, benzoin benzoate, methyl benzoin benzoate, benzoin dimethyl ketal, 2,4-diethylthioxanthone,α-hydroxycyclohexyl phenyl ketone, benzyldiphenyl sulfide, tetra methylthiuram monosulfide, azobisisobutyronitrile, benzil, dibenzyl, diacetyl, β-chloroanthraquinone and 2,4,6-trimethylbenzoyldiphenylphosphine oxide.

Although the content of radiation curable component (E) is appropriately determined in accordance with the characteristics of added components, the radiation curable component (E) is preferably used in an amount of about 1 to 30 parts by weight, more preferably 5 to 15 parts by weight per 100 parts by weight of the sum of components A and B.

The flexible component (F) is a component capable of retaining flexibility even after curing of the epoxy component (B), and consists of a thermoplastic resin or elastomer. This flexible component (F) is preferably used in an amount of 1 to 40 parts by weight, more preferably 4 to 30 parts by weight and especially preferably 4 to 25 parts by weight per 100 parts by weight of the epoxy resin (B).

The flexible component (F) has a glass transition temperature (Tg) of preferably about -40 to 80°C, especially preferably about -30 to 10°C. The molecular weight of the flexible component (F) is preferably in the range of about 10000 to 1000000, especially preferably about 20000 to 600000. However, this does not apply to the flexible component (F) when internally crosslinked.

The flexible component (F) refers to a component that is substantially not cured by radiation or heating, and may be a polymer, or a graft component of a polymer, or a block component of a polymer.

The flexible component (F) is uniformly dispersed in the HPSA layer after curing to reduce the brittleness of the cured layer and enhance resistance to any external stress. Further, the flexible component (F) is preferably uniformly dispersed or mixed in the epoxy resin (B). Accordingly, the flexible component (F) is preferably in microparticulate form, or soluble or easily soluble in an organic solvent, such as toluene or methyl ethyl ketone.

As the flexible component (F) in microparticulate form, use is made of particles of 0.1 to 5 µm, preferably 0.1 to 1 µm diameter.

With respect to the flexible component (F) that is soluble in an organic solvent, it is known that, depending on the curing process, the flexible component (F) undergoes a phase separation from the epoxy resin (B) so as to form a binary phase system. Examples of flexible components (F) that are soluble in an organic solvent include a saturated polyester resin, a liquid NBR, a liquid chloroprene rubber, a urethane rubber, a polyolefin resin, a silicone oil, etc. Of these, a saturated polyester resin is preferred.

Examples of flexible components (F) in microparticulate form include acrylic rubber microparticles prepared by emulsion polymerization, a block polyester elastomer such as polyether polyester, polyethylene microparticles, silicone rubber microparticles, etc. Of these, acrylic rubber microparticles and a block polyester elastomer are preferred.

A flexible component (F) in microparticulate form is commercially available in the form of a dispersion in an epoxy resin. Also, as mentioned above, use can be made of a modified resin resulting from prior modification of the epoxy resin (B) and the flexible component (F). This modified resin is known as an alloy-modified resin or rubber-blend-modified resin.

Examples of such modified materials include various rubber-modified epoxy resins (for example, NBR-modified or CTBN-modified), urethane-modified epoxy resin, silicone-modified epoxy resin, etc.

Examples of rubber-modified epoxy resins include Adeka Resin EP-4023 (trade name, produced by Asahi Denka Co., Ltd.), Adeka Resin EP-4024 (trade name, produced by Asahi Denka Co., Ltd.), Adeka Resin EP-4026 (trade name, produced by Asahi Denka Co., Ltd.) and Adeka Resin EPR-20 (trade name, produced by Asahi Denka Co., Ltd.).

Examples of urethane-modified epoxy resins include Adeka Resin EPU-6 (trade name, produced by Asahi Denka Co., Ltd.), Adeka Resin EPU-73 (trade name, produced by Asahi Denka Co., Ltd.) and Adeka Resin EPU-78-11 (trade name, produced by Asahi Denka Co., Ltd.).

An electrically conductive or thermally conductive filler, such as gold, silver, copper, nickel, aluminum, stainless steel, carbon, or filler consisting of ceramic, nickel or aluminum, etc. coated with silver, may be added as the filler (G) for the purpose of imparting an electrical conductivity or thermal conductivity after die bonding. Also, a nonconductive filler, such as asbestos, silica, glass, mica, chromium oxide, titanium oxide or a pigment, may be added. These fillers may be added in an amount of about 0 to 400 parts by mass per 100 parts by mass of the sum of components (excluding fillers) constituting the HPSA layer.

As the other components (H), a crosslinking agent, such as an organic polyisocyanate compound or an organic polyimine compound, can be added to the HPSA composition for the purpose of regulation of initial adhesion strength and cohesive force.

As the organic polyisocyanate compound, there can be mentioned, for example, an aromatic polyisocyanate compound, an aliphatic polyisocyanate compound, an alicyclic polyisocyanate compound and trimers of these polyisocyanate compounds. Representative examples of the organic polyisocyanate compounds include 2, 4-tolylene diisocyanate, 2,6-tolylene diisocyanate, 1,3-xylylene diisocyanate, 1,4-xylylene diisocyanate, diphenylmethane-4,4'-diisocyanate, diphenylmethane-2,4'-diisocyanate, 3-methyldiphenylmethane diisocyanate, hexamethylene diisocyanate, isophorone diisocyanate, dicyclohexylmethane-4,4'-diisocyanate, dicyclohexylmethane-2,4'-diisocyanate and lysine isocyanate. Use may also be made of urethane prepolymers with isocyanate terminal groups obtained by reacting these polyisocyanate compounds with polyol compounds. Examples thereof include trimethylolpropane-modified tolylene diisocyanate and the like.

Examples of the organic polyimide compounds include N,N'-diphenylmethane-4,4'-bis(1-aziridinecarboxyamide), trimethylolpropane-tri-β-aziridinylpropionate, tetramethylolmethane-tri-β-aziridinylpropionate and N,N'-toluene-2,4-bis(1-aziridinecarboxyamido)triethylene melamine. These crosslinking agents are preferably added to the HPSA composition in an amount of 0 to 5 wt.%, more preferably 0.1 to 1 wt.%.

Furthermore, an antistatic agent can be added to the above HPSA composition. The addition of the antistatic agent inhibits the build-up of static electricity at the time of expanding or pickup, thereby enhancing the chip reliability. As the antistatic agent, use can be made of, for example, generally known anionic, cationic, nonionic and amphoteric-ion antistatic agents. The antistatic agent is preferably added to the HPSA composition in an amount of 0 to 50 wt.%, more preferably 0 to 30 wt.%.

The HPSA sheet of the present invention can be obtained by coating a base material with a HPSA composition composed of the above components by common means, such as a roll-knife coater, gravure coater, die coater or reverse coater, and thereafter drying thereof. Also, the HPSA sheet of the present invention can be obtained by coating a release sheet with the HPSA composition by the above means, drying thereof to thereby form a HPSA layer and transferring the HPSA layer to a base material.

As the base material, use is made of, for example, a polyethylene film, a polypropylene film, a polybutene film, a polybutadiene film, a polymethylpentene film, a polyvinyl chloride film, a vinyl chloride copolymer film, a polyethylene terephthalate film, a polybutylene terephthalate film, a polyurethane film, an ethylene vinyl acetate film, an ionomer resin film, an ethylene/(meth)acrylic acid copolymer film, an ethylene/ (meth) acrylic ester copolymer film, a polystyrene film, a polycarbonate film, a fluorinated film or the like. The base material may be a single layer of any of these films or a laminate thereof. A material that is permeable to the employed radiation is chosen as the base material.

The surface tension of the base material is preferably 40 mN/m or less, still preferably 37 mN/m or less and especially preferably 35 mN/m or less. This would enable transfer bonding of the HPSA layer of the HPSA sheet according to the present invention to an adherend. The base material with the above low surface tension can be obtained by appropriate selection of material, or by performing release treatment through coating of the surface of base material with a silicone resin or the like. Furthermore, use can be made of a paper base material, for example, glassine paper, coated papers such as a clay coated paper and resin coated paper, or laminated papers such as a polyethylene laminated paper and polypropylene laminated paper. The thickness of these base materials is generally in the range of about 10 to 300 µm, preferably 20 to 200 µm and especially preferably 50 to 150 µm. According to necessity, the HPSA composition can be dissolved or dispersed in a solvent before the coating operation.

It is generally preferred that the thickness of the HPSA layer of the HPSA sheet according to the present invention be in the range of 3 to 100 µm, especially 10 to 60 µm.

Now, the process for producing a semiconductor device according to the present invention will be described. In the process of the present invention, first, the HPSA sheet is fixed on a tape mounting device by means of a ring frame. One major surface of a silicon wafer is attached on the HPSA layer of the HPSA sheet, and slight pressure is applied to thereby immobilize the wafer.

Thereafter, when the HPSA layer contains a radiation curable component, the HPSA sheet is exposed to radiation from the base material side so as to increase the cohesive force of the HPSA layer, thereby lowering the adherence thereof to the base material. Subsequently, with the use of dicing means such as a dicing saw, the silicon wafer is diced into IC chips. The depth of the dicing is to agree with the sum of the thickness of silicon wafer and the thickness of HPSA layer with any abrasion by the dicing saw being taken into account.

The exposure to radiation rays may be carried out after dicing, or after the following expanding step. According to necessity, the HPSA sheet is expanded. Then, the spaces between the IC chips are enlarged with the result that pickup of IC chips can be facilitated.

In this pickup of IC chips, the diced HPSA layer can be detached from the base material whilst remaining fixed on the back side of the IC chips. The thus obtained IC chips are mounted through the HPSA layer onto a die pad part. The die pad part is heated prior to the attachment of the IC chips or immediately after the attachment. The heating temperature is generally in the range of 80 to 200°C, preferably 100 to 180°C. The heating time is generally in the range of 0.1 sec to 5 min, preferably 0.5 sec to 3 min. Chip mounting pressure is generally in the range of 1 kPa to 100 MPa.

After the mounting of IC chips onto the die pad, further heating can be effected so as to bring about curing of the HPSA layer with the result that the IC chips and the die pad part are strongly bonded to each other.
For this heating curing, the heating temperature is generally in the range of 80 to 200°C, preferably 100 to 180°C, and the heating time is generally in the range of 1 to 120 min, preferably 10 to 90 min.

In the thus obtained semiconductor device, the storage modulus of cured HPSA is 1.0×10⁷ Pa or below at 100°C, and 1.0×10⁵ Pa or above at 160°C. In an IR reflow operation, etc., satisfactory package reliability can be attained. In addition to the above method of use, the HPSA sheet of the present invention can be used in the bonding of semiconductor compounds, glass, ceramics, metals, etc.

### INDUSTRIAL APPLICABILITY

With respect to the HPSA sheet of the present invention, the storage modulus at high temperature can successfully be lowered while maintaining high adhesion strength. As a result, there can be produced a semiconductor device of high reliability with a strength capable of preventing delamination, etc. at a substrate-chip or chip-chip bonding interface after a 240 to 260°C reflow operation subsequent to the application of heat and humidity.

### EXAMPLES

The present invention will be further illustrated below with reference to the following Examples, which however in no way limit the scope of the invention.

### Preparation of HPSA sheet for semiconductors

Base material: A polyethylene film (100 µm thickness and 32 mN/m surface tension) was used.

HPSA: The compositions are listed in Table 1. HPSA sheets for semiconductors were obtained by coating the base material with each of the listed HPSA compositions and drying the coated material so that the coating thickness was 20 µm.

The storage modulus and glass transition temperature (temperature at which tan δ was maximized) of the HPSA layers after thermal curing were measured in the following manner. The base material was coated with each of the HPSAs and dried so that the coating thickness was 200 µm. Then, the base material was peeled off (when a radiation curable component was included, the delamination was carried out after exposure to radiation). Thermal curing of the HPSA layers was carried out at 160°C for 60 min. With respect to the samples obtained, the storage modulus and glass transition temperature were measured by means of a dynamic viscoelasticity meter (RHEOVIBRON DDV-II-EP, manufactured by Orientic Corporation) at a frequency of 11 Hz. The results are listed in Table 2.

**Table 1**

| Hardenable pressure-sensitive adhesive composition (pts. wt.) | | | | | | | | | | | | | |
|---|---|---|---|---|---|---|---|---|---|---|---|---|---|
| | A | B | | | | | C | | D | E | F | H | Total |
| | | B1 | B2 | B3 | B4 | B5 | C1 | C2 | | | | | |
| Example 1 | 16 | 41 | | 40 | | | 0.7 | 0.8 | 1 | | | 0.5 | 100 |
| Example 2 | 14 | 36.5 | | 36.5 | 2.5 | | 0.5 | 0.5 | 0.5 | | 9 | | 100 |
| Example 3 | 13.5 | 37 | | 37 | | | 0.7 | 0.7 | 0.6 | 10 | | 0.5 | 100 |
| Example 4 | 12 | 33 | | 33 | 3 | | 0.5 | 0.5 | 0.5 | 9 | 8.5 | | 100 |
| Example 5 | 16 | | 51 | 30 | | | 0.7 | 0.8 | 1 | | | 0.5 | 100 |
| Example 6 | 14 | | 36.5 | 2.5 | 36.5 | | 0.5 | 0.5 | 0.5 | | 9 | | 100 |
| Comp. Ex. 1 | 16 | | | 40 | | 41 | 0.7 | 0.8 | 1 | | | 0.5 | 100 |
| Comp. Ex. 2 | 14 | | | 36.5 | 2.5 | 36.5 | 0.5 | 0.5 | 0.5 | | 9 | | 100 |
| Comp. Ex. 3 | 13.5 | | | 37 | | 37 | 0.7 | 0.7 | 0.6 | 10 | | 0.5 | 100 |
| Comp. Ex. 4 | 12 | | | 33 | | 33 | 0.5 | 0.5 | 0.5 | 9 | 8.5 | | 100 |
| Comp. Ex. 5 | 16 | | | 30 | | 51 | 0.7 | 0.8 | 1 | | | 0.5 | 100 |
| Comp. Ex. 6 | 14 | | | 36.5 | 2.5 | 36.5 | 0.5 | 0.5 | 0.5 | | 9 | | 100 |
| (A) pressure-sensitive component: copolymer of 900,000 weight average molecular weight and -28°C glass transition temperature obtained by copolymerization of 55 parts by weight of butyl acrylate, 10 parts by weight of methyl methacrylate, 20 parts by weight of glycidyl methacrylate and 15 parts by weight of 2-hydroxyethyl acrylate. | | | | | | | | | | | | | |
| (B) epoxy resin: | | | | | | | | | | | | | |
| (B1) epoxy resin having a bisphenol skeleton and a flexible skeleton (EXA-4850-150 produced by Dainippon Ink And Chemicals, Inc., having an epoxy equivalent of 450 g/eq and a glass transition temperature after curing of 29°C), | | | | | | | | | | | | | |
| (B2) epoxy resin having a bisphenol skeleton and a flexible skeleton (EXA-4850-1000 produced by Dainippon Ink And Chemicals, Inc., having an epoxy equivalent of 350 g/eq and a glass transition temperature after curing of 62°C), | | | | | | | | | | | | | |
| (B3) general-purpose epoxy resin: solid bisphenol A type epoxy resin (having an epoxy equivalent of 800 to 900 g/eq and a glass transition temperature after curing of 120°C), | | | | | | | | | | | | | |
| (B4) general-purpose epoxy resin: solid epoxy resin having a dicyclopentadiene skeleton (EXA-7200HH produced by Dainippon Ink And Chemicals, Inc., having an epoxy equivalent of 275 to 280 g/eq and a glass transition temperature after curing of 185°C), and | | | | | | | | | | | | | |
| (B5) general-purpose epoxy resin: liquid bisphenol A type epoxy resin (Epicoat 828 produced by Japan Epoxy Resins Co., Ltd., having an epoxy equivalent of 184 to 194 g/eq and a glass transition temperature after curing of 140°C). | | | | | | | | | | | | | |
| (C) curing agent: | | | | | | | | | | | | | |
| (C1) Adeka Hardener 3636AS produced by Asahi Denka Co., Ltd., and | | | | | | | | | | | | | |
| (C2) Curezol 2PHZ produced by Shikoku Chemicals Corporation. | | | | | | | | | | | | | |
| (D) silane coupling agent: A-1110 produced by Nippon Unicar Company, Limited. | | | | | | | | | | | | | |
| (E) radiation curable component: composition composed of: 100 parts by weight of acrylate having a dicyclopentadiene skeleton (Kayarad R684 produced by Nippon Kayaku Co. Ltd.) and 3 parts by weight of 2,4,6-trimethylbenzoyldiphenylphosphine oxide. | | | | | | | | | | | | | |
| (F) flexible component: thermoplastic polyester (Vylon 220 produced by Toyobo Co., Ltd.). | | | | | | | | | | | | | |
| (H) crosslinking agent: trimethylolpropane-modified tolylene diisocyanate (Coronate L produced by Nippon Polyurethane Industry Co., Ltd.). | | | | | | | | | | | | | |

**Table 2**

| | Av. epoxy equivalent of epoxy resin (g/eq) | Epoxy resin content, pts. wt. per 100 pts. wt. of component (A) | Elasticity after thermal curing (Pa) | | Glass transition temp., Tg (°C) |
|---|---|---|---|---|---|
| | | | 100°C | 160°C | |
| Example 1 | 648 | 506 | 3.0×10⁶ | 3.2×10⁶ | 88 |
| Example 2 | 638 | 539 | 5.0×10⁶ | 5.1×10⁶ | 79 |
| Example 3 | 650 | 548 | 4.0×10⁶ | 3.8×10⁶ | 82 |
| Example 4 | 633 | 575 | 7.0×10⁶ | 4.7×10⁶ | 81 |
| Example 5 | 535 | 506 | 3.0×10⁶ | 3.1×10⁶ | 85 |
| Example 6 | 589 | 539 | 6.0×10⁶ | 5.4×10⁶ | 87 |
| Comp. Ex. 1 | 515 | 506 | 4.0×10⁸ | 2.2×10⁷ | 141 |
| Comp. Ex. 2 | 511 | 539 | 8.0×10⁸ | 4.0×10⁷ | 123 |
| Comp. Ex. 3 | 520 | 548 | 7.0×10⁸ | 4.1×10⁷ | 131 |
| Comp. Ex. 4 | 509 | 575 | 7.0×10⁸ | 5.3×10⁷ | 126 |
| Comp. Ex. 5 | 434 | 506 | 5.0×10⁸ | 3.8×10⁷ | 127 |
| Comp. Ex. 6 | 511 | 539 | 9.0×10⁸ | 6.9×10⁷ | 122 |

With respect to the thus obtained HPSA sheets, test 1 (peel strength), test 2 (package reliability) and test 3 (estimation of warpage by thermal curing) were carried out in the manners described later. The results are listed in Table 3.

**Table 3**

| | Test 1 | Test 2 | Test 3 |
|---|---|---|---|
| Example 1 | 7.1 | A | 5 |
| Example 2 | 6.9 | A | 7 |
| Example 3 | 6.7 | B | 9 |
| Example 4 | 7.5 | A | 7 |
| Example 5 | 7.1 | A | 9 |
| Example 6 | 8.3 | A | 7 |
| Comp. Ex. 1 | 5.1 | C | 32 |
| Comp. Ex. 2 | 4.9 | D | 41 |
| Comp. Ex. 3 | 5.3 | E | 29 |
| Comp. Ex. 4 | 5.5 | D | 38 |
| Comp. Ex. 5 | 3.9 | C | 32 |
| Comp. Ex. 6 | 4.7 | D | 35 |
| A: None of lifting/delamination and package cracking. | | | |
| B: Some degree of lifting was observed, but there was no package cracking. | | | |
| C: Partial lifting/delamination or package cracking were observed. | | | |
| D: Lifting/delamination or package cracking occurred across the specimen. | | | |
| E: Complete delamination was observed. | | | |

### Test 1 (peel strength)

The HPSA sheet of each of the Examples and Comparative Examples was stuck to a polished surface (polished with abrasive #2000) of 350µm thick silicon wafer. Thereafter, when the HPSA layer contained a radiation curable component, the base material side was exposed to ultraviolet light. Then the wafer was diced into chips of 12 mm × 12 mm size. The degree of cut-in at the dicing was such that the base material was incised by 10 µm. Subsequently, upward thrust with a needle from the side of HPSA sheet was carried out so as to achieve pickup in such a manner that the chips with the HPSA layer were detached from the interface of base material. The obtained silicon chips were attached through the HPSA layer onto a 150 µm thick copper sheet, and bonding/curing was conducted in a 160°C thermostat for 60 min. Thus, samples were obtained. The silicon chip side of each of the samples was bonded and secured to a hard horizontal board, and the copper sheet was peeled at an angle of 90° and at a rate of 50 mm/min. The adhesion strength exhibited at the peel was measured (N/10 mm width).

### Test 2 (package reliability)

### (1) Production of semiconductor chip

The HPSA sheet of each of the Examples and Comparative Examples was stuck to the surface of a silicon wafer (100 mm diameter and 200 µm thickness) polished with abrasive #2000 with the use of a tape mounter (Adwill RAD2500, manufactured by Lintec Corporation), and fixed on a ring frame for wafer dicing. Thereafter, when the HPSA layer contained a radiation curable component, the base material side was exposed to ultraviolet light with the use of a UV irradiation machine (Adwill RAD2000, manufactured by Lintec Corporation). Subsequently, dicing into chips of 9 mm × 9 mm size was performed with the use of a dicing machine (AWD-4000B manufactured by Tokyo Seimitsu Co. Ltd.). The degree of cut-in at the dicing was such that the base material was incised by 10 µm. Subsequently, upward thrust with a needle from the side of HPSA sheet was carried out so as to achieve pickup in such a manner that the chips with the HPSA layer were detached from the interface of base material.

### (2) Production of IC package

Substrate for IC package (laminate of polyimide film (50 µm) and electrolytic copper foil (20 µm), having, as a die pad part, sequentially patternized gold plating and palladium plating superimposed on the copper foil and further a solder resist of 25 µm height) was provided. The above semiconductor chips were attached through the HPSA layer sheet onto the die pad part of the substrate for IC package under pressure at conditions of 120°C/50 MPa/1 sec, thereby carrying out chip mounting. Thereafter, thermal curing was conducted under conditions of 160°C/60 min. Further, high pressure sealing was effected by molding the chip mount side of the substrate with a molding resin into a given configuration and curing the resin under conditions of 175°C/6 hr. Subsequently, a solder ball was fitted on the unsealed side of the substrate, thereby completing a BGA (Ball Grid Allay) type IC package.

### (3) Estimation of package reliability

Each of the obtained IC packages was allowed to stand at 85°C in 60% RH for 168 hr so as to absorb moisture. Thereafter, the occurrence of lifting/delamination of the bonded part and the occurrence of package cracking upon IR reflow (conducted twice with a maximum temperature of 260°C) were assessed by observation through a scanning type ultrasonic flaw detector and by cross-section observation.

### Test 3 (estimation of warpage by thermal curing)

The HPSA sheet of each of the Examples and Comparative Examples was stuck to a 100 mm × 100 mmpolyimide film (Kapton 300H, produced by Ube Industries, Ltd.). Thereafter, when the HPSA layer contained a radiation curable component, the base material side was exposed to ultraviolet light with the use of a UV irradiation machine (Adwill RAD2000, manufactured by Lintec Corporation). The base material was detached, and thermal curing was conducted under conditions of 160°C/60 min. The polyimide film with cured HPSA layer was allowed to stand until cooling to room temperature, and, with the polyimide film surface side down, was placed on a horizontal plane. The warpage was assessed by measuring the height (unit: mm) of lifting polyimide film ends.

## Claims

1. A hardenable pressure-sensitive adhesive sheet for semiconductor, comprising a base material and, superimposed thereon, a hardenable pressure-sensitive adhesive layer comprising a pressure-sensitive component (A) and an epoxy resin (B), wherein the hardenable pressure-sensitive adhesive layer after thermal curing has a storage modulus of 1.0×10⁷ Pa or below at 100°C and 1.0×10⁵ Pa or above at 160°C.

2. The hardenable pressure-sensitive adhesive sheet as claimed in claim 1, wherein the hardenable pressure-sensitive adhesive layer contains a radiation curable component.

3. A process for producing a semiconductor device, comprising the steps of:
sticking a semiconductor wafer to the hardenable pressure-sensitive adhesive layer of the hardenable pressure-sensitive adhesive sheet of claim 1,
dicing the semiconductor wafer into IC chips,
detaching the IC chips with the hardenable pressure-sensitive adhesive layer from the base material,
attaching the IC chips on a lead frame with the hardenable pressure-sensitive adhesive layer interposed therebetween, and
heating so that the hardenable pressure-sensitive adhesive layer exerts an adhesive strength to thereby accomplish bonding of the IC chips to the lead frame.

4. A process for producing a semiconductor device, comprising the steps of:
sticking a semiconductor wafer to the hardenable pressure-sensitive adhesive layer of the hardenable pressure-sensitive adhesive sheet of claim 2,
dicing the semiconductor wafer into IC chips, irradiating the hardenable pressure-sensitive adhesive layer either prior to the dicing or after the dicing so as to cure the hardenable pressure- sensitive adhesive layer,
detaching the IC chips with the hardenable pressure-sensitive adhesive layer from the base material,
attaching the IC chips on a lead frame with the hardenable pressure-sensitive adhesive layer interposed therebetween, and
heating so that the hardenable pressure-sensitive adhesive layer exerts an adhesive strength to thereby accomplish bonding of the IC chips to the lead frame.
